# EUROPEAN PATENT APPLICATION

(11) **EP 1 906 327 A2**
(43) Date of publication of application: **02.04.2008**
(21) Application number: 07116393.5
(22) Date of filing: 14.09.2007
(51) Int. Cl.: G06F 17/50

(54) **Method and system for creating tool specification**

(30) Priority: 26.09.2006 US 526673
(71) Applicant: General Electric Company, Schenectady, NY 12345 (US)
(72) Inventor: Lanzarotta, James Andrew, West Chester, OH 45069 (US); Meece, Roy Dean, Hampstead, NC 28443 (US); Hermann, Leonard Joseph, Cincinnati, OH 45224 (US); Baird, Jr.,, James Allen, Amelia, OH 45102 (US); Geverdt, Gerald Roger, Cincinnati, OH 45241 (US); Hughes, Leon Eliot, Cincinnati, OH 45232 (US); Fanelli, Nick, Harrison, OH 45030 (US)
(74) Representative: Illingworth-Law, William Illingworth

(57) **Abstract**

A method (100) which broadly comprises the following steps: a) submitting (106) to a tool data library (104) a request (102) which includes the basic tool parameters (116) to generate tool specification parameters; (b) generating (122) tool specification parameters from the tool data library (104) based on the submitted basic tool parameters (118); (c) importing (124) the generated tool specification parameters into a parametric tool template (130); and (d) processing (132) the imported tool specification parameters (128) and parametric tool template (13) using a CAD software program (134) to create (136) a tool specification (138), wherein the tool specification (138) comprises a representation of a three-dimensional model (800) of the tool and associated drawing specifications (910 through 1150) for the tool. Also disclosed is a system (100) which broadly comprises: a requestor workstation; a tool data library (104); a source of parametric tool templates (130) modifable with imported tool parameters (128); and a source of a CAD software program (134) for processing (132) the parametric tool templates (130) and imported tool parameters (128) to create (136) tool specifications (138).

## Description

### BACKGROUND OF THE INVENTION

This invention broadly relates to a method and system for creating a tool specification comprising a representation of a three-dimensional model and associated drawing specifications of the tool.

The procurement of cutting tools with a unique geometry or geometries may require the preparation of drawing specifications so that the tool manufacturer may make the tool according to this unique geometry or geometries. Current drawings and drafting methods may fail to accurately and completely define the correct geometry of these tools, especially if that geometry is extremely complex. These drawing specifications may also be insufficient to ensure consistent results across multiple lots and multiple manufacturers of the tool. Wide variations in tool manufacture may also cause a significant reduction in tool life, performance failures, damage to the product or workpiece which the tool is used with, etc.

Traditional two-dimensional drafting techniques and methodologies may be used to render basic images of the tool to which dimensions and tolerances may be added to create a drawing specification. These two-dimensional drafting techniques and methodologies may range from crude raster images of hand drawings to more sophisticated electronic graphic files developed using, for example, commercially available computer aided design (CAD) software applications. For example, an electronic graphic file of a similar drawing, or a generic template, may be modified to reflect dimensions, tolerances, notes, etc., for information or data believed to be relevant to the tool drawing specification.

Variation in the detail specified for the tool drawing specification may be influenced by such factors as the draftsman's knowledge or skill, the ability to pictorially render the desired image, the geometric features thought to affect tool performance, the educated speculation of dimensions and tolerances expected to produce the desired results with the tool, etc. This process of creating a tool drawing specification may thus be labor intensive, time consuming, and potentially unable to deliver consistent results. The resulting tool drawing specifications may also conform to no standard, may contain errors and inconsistencies which prove difficult or impossible to physically manufacture, may provide inadequate tool performance, etc.

Accordingly, a method and system may be needed to quickly, easily and consistently creating a tool drawing specification which provides accuracy and completeness sufficient to achieve consistent and correct manufacture of the tool, even across multiple tool lots and/or manufacturers.

### BRIEF DESCRIPTION OF THE INVENTION

An embodiment of this invention is broadly directed at a method comprising the following steps:
(a) submitting to a tool data library a request to create a tool specification, wherein the request includes basic tool parameters for creating the tool specification;
(b) generating tool specification parameters from the tool data library based on the submitted basic tool parameters;
(c) importing the generated tool specification parameters into a parametric tool template; and
(d) processing the imported tool specification parameters and parametric tool template using a CAD software program to create the tool specification, wherein the tool specification comprises a representation of a three-dimensional model of the tool and associated drawing specifications for the tool.

Another embodiment of this invention is broadly directed at a system comprising:
a requestor workstation for at least entering search requests and tool parameters and for at least reviewing created tool specifications;
a tool data library accessible by the requestor workstation and comprising pre-existing tool specification data and pre-existing tool parameter data;
a source of parametric tool templates modifiable with imported tool parameters; and
a source of a CAD software program for processing the imported tool parameters and parametric tool templates to create tool specifications, wherein each created tool specification comprises a three-dimensional representation of a model of a tool and associated drawing specifications for the tool.

### BRIEF DESCRIPTION OF THE DRAWINGS

Embodiments of the present invention will now be described, by way of example only, with reference to the accompanying drawings, in which:
FIG. 1 is a flow chart illustrating an embodiment of a method and system for creating a new tool specification.
FIG. 2 is a computer screen capture illustrating a blank screen of an embodiment of the method and system of FIG. 1 at the start of a search of tool data library for pre-existing tool specifications.
FIG. 3 is a computer screen capture illustrating the search results obtained after the search request is transmitted to the tool data library.
FIG. 4 is a computer screen capture illustrating a dialog box which may be presented to request the entry of basic tool parameters for the new tool specification.
FIG. 5 is a computer screen capture illustrating the completed entry of the basic tool parameters into the dialog box to be submitted to the tool data library for the new tool specification.
FIG. 6 is a computer screen capture illustrating basic tool parameters used to retrieve "best practice" tool parameters from the tool data library for the new tool specification.
FIG. 7 is a computer screen capture illustrating an exemplary detailed listing of the tool specification parameters for creating the new tool specification.
FIG. 8 is an enlarged view of a portion of the computer screen capture of FIG. 2 showing a three dimensional solid tool model created from the tool specification parameters.
FIG. 9 is an enlarged view of a computer screen capture representing a portion of the associated drawing specifications created for the new tool specification.
FIG. 10 is an enlarged view of a computer screen capture representing another portion of the associated drawing specifications of FIG. 9.
FIG. 11 is an enlarged view of a computer screen capture representing yet another portion of the associated drawing specifications of FIG. 9.

### DETAILED DESCRIPTION OF THE INVENTION

As used herein, the term "tool" refers to a device, part, component, bit, implement, instrument, etc. which is moved, turned, spun, rotated, etc., to cut, grind, shape, drill, mill, ream, bore, etc., a material, workpiece, etc. Tools may include cutting tools such as mills (e.g., ball nose end mills, flat end mills, chamfer mills, etc.), drills, bores, reamers, countersinks, counterbores, turning inserts (e.g., for grooving, forming, etc.), etc.

As used herein, the term "tool parameters" refers to geometric and non-geometric data elements which may be used to uniquely describe the characteristics, properties, dimensions, composition, shape, function, features, etc., of a particular tool.

As used herein, the term "geometric tool parameters" refers to those data elements which may be used to define the three-dimensional shape, configuration, design, features, etc., of the tool and which may be used to create a three-dimensional model of the tool, as well as the nominal drawing specifications of the tool.

As used herein, the term "non-geometric tool parameters" refers to qualitative data elements which are of a non-numeric format and which in and of themselves do not represent geometric values necessary in defining the three-dimensional shape, configuration, design, features, etc., of the tool, or in creating a three-dimensional model of the tool, as well as the associated drawing specifications of the tool.

As used herein, the term "basic tool parameters" refers to a set of tool parameters which describe generic profile dimensions of a specific tool type. For example, for rotary tools (e.g., end mills, drills, reamers, etc.), these basic tool parameters may include the cutting diameter, shank diameter, flute length, overall length, corner radius, holding style, etc. When coupled with a specific application (e.g., workpiece material), the remaining parameters which define the other details of the geometric features of the tool may be retrieved from a tool data library based on the basic tool parameters submitted. Collectively, the basic tool parameters and the remaining tool parameters retrieved provide a complete set of tool specification parameters in creating, constructing, etc., a three-dimensional model of the tool, as well as the associated drawing specification, of the tool specification.

As used herein, the term "tool specification parameters" refers to a complete set of tool parameters which define the basic form, fit, function, shape, performance, use, etc., necessary to create a tool specification for a tool. These tool specification parameters may comprise the basic tool parameters, as well as any remaining tool parameters derived by the application of knowledge-based rules from pre-existing tool parameter data in the tool data library (referred to hereafter as "best practices") to these basic tool parameters.

As used herein, the term "tool specification" refers to a set of data, parameters, etc., which uniquely describe, define, etc., the tool in sufficient detail so that the tool may be appropriately manufactured, described, inspected, etc., for the intended use of the tool.

As used herein, the term "pre-existing tool specification" refers to one or more tool specifications which are already present and in existence in a tool data library.

As used herein, the term "pre-existing tool parameter" refers to one or more tool parameters which are already present and in existence in a tool data library.

As used herein, the term "library" refers to an electronic database containing searchable, retrievable, storable, etc., data useful in embodiments of the method and system of this invention and which may be stored or reside on, as well as be loaded or installed from, one or more floppy disks, CD ROM disks, hard disks or any other form of suitable non-volatile electronic storage media. A library useful in embodiments of the method and system of this invention may be accessed locally or remotely, may be downloaded by remote transmission, etc.

As used herein, the term "tool data library" refers to a library which stores searchable and retrievable pre-existing tool specification data, pre-exiting tool parameter data, knowledge-based rules for deriving "best practice" tool parameters from pre-exiting tool parameters, etc., and any combination thereof.

As used herein, the term "criteria" with regard to a request refers to tool parameter data, etc., which define, specify, *etc.,* those features, properties, etc., relevant to obtaining from a tool data library pre-existing tool specification data, pre-exiting tool parameter data, knowledge-based rules for deriving "best practice" tool parameters from pre-exiting tool parameters, etc.

As used herein, the term "request" refers to any action initiated by a requestor to search, retrieve, obtain, etc., data, information, results, etc., which may be of interest to the requestor, for example, searching a tool data library, creating a model and drawing specifications from tool parameters provided, etc.

As used herein, the term "template" refers to a starting or existing pattern, framework, model, structure, outline, guide, etc., containing the knowledge-based rules necessary to create, generate, etc., new patterns, structures, etc.

As used herein, the term "parametric" refers to the use of a variable set of parameters upon which rules and knowledge may be applied in order to create a unique tool specification.

As used herein, the term "parametric tool template" refers to one or more electronic computer aided design (CAD) templates which contain the knowledge-based rules necessary to create three-dimensional models and associated drawing specifications for a variety of geometric tool shapes when provided, modified, updated, etc., with a set of data (i.e., tool parameters) which represents the tool geometry desired.

As used herein, the term "tool model" refers to an electronic CAD file containing a three-dimensional model, and associated drawing specifications for a tool derived from a set of tool parameter data imported and applied to a parametric tool template.

As used herein, the term "complex shape" refers to a geometric shape which may result from the application and use of the parametric templates and which has surfaces, edges, configurations, angles, features, etc., which, without the use of, for example, a CAD software program, might be difficult or impossible to define, describe, design, etc., in the context of a two-dimensional model and/or drawing specification.

As used herein, the term "three-dimensional" refers to a mathematical representation of a geometric entity in the three dimensions according to, for example, a standard

Cartesian coordinate system.

As used herein, the term "three-dimensional model of the tool" refers to an electronic representation of the geometric shape of the tool within the three dimensions of an electronic CAD file.

As used herein, the term "drawing specifications" refers to a two-dimensional representation (e.g., blue prints) which illustrate the tool such that the tool may be described and manufactured.

As used herein, the term "importing" refers to transmitting, applying, etc., tool parameters to a parametric CAD template file.

As used herein, the term "requestor" refers to anyone using embodiments of the method and system of the present invention.

As used herein, the term "requestor workstation" refers to any input and/or output device which may be used by a requestor to provide input, obtain access, *etc.,* to embodiments of the method and system of the present invention.

As used herein, the term "software" refers to any form of programmed machine-readable language or instructions (e.g., object code) that, when loaded or otherwise installed, provides operating instructions to a machine capable of reading those instructions, such as a computer or other computer program reader. Software useful in embodiments of the method and system of the present invention may be stored or reside on, as well as be loaded or installed from, one or more floppy disks, CD ROM disks, hard disks or any other form of suitable non-volatile electronic storage media. Software useful in embodiments of the method and system of the present invention may also be installed by downloading or other form of remote transmission.

As used herein, the term "CAD software program" refers to computer assisted design (CAD) software programs which may be useful in designing two-dimensional and especially three-dimensional objects (e.g., tools). CAD software programs may be used to design, develop, create draw, represent, etc., the object of interest and may be used throughout the engineering process, including conceptual design and layout, detailed engineering and analysis of components and definition of manufacturing methods, etc. Some examples of CAD software programs useful in embodiments of the method and system of this invention include SOLID EDGE@ sold by

Unigraphics®, CATIA® by IBM®, as well as programs produced by PRO-Engineer, IIDEAS, etc. The term CAD also refers to programs identified as computer-assisted, computer-aided drafting, including computer-aided design and drafting (CADD) programs; computer-aided industrial design (CAID) programs; computer-aided architectural design (CAAD) programs, etc.

As used herein, the terms "transmission," "transmitting", "transmit" and the like refer to any type, manner, etc. of providing, supplying, inputting or otherwise transmitting information or data. Transmission of information/data herein may be carried out electronically, including the use of wired electronic methods, wireless electronic methods or combinations thereof. Electronic transmissions may be carried out by a variety of local or remote electronic transmission methods, such as by using Local or Wide Area Network (LAN or WAN)-based, Internet-based, or web-based transmission methods, cable television or wireless telecommunications networks, or any other suitable local or remote transmission method.

As used herein, the term "computer" may refer to a personal computer (portable or desktop), server, mainframe computer, etc.

As used herein, the terms "data" and "information" refer interchangeably to information, facts, etc., in numerical and/or electronic form which may be an input, an output (e.g., a result), or both.

As used herein, the term "comprising" means various operations, steps, data, stations, components, parts, devices, techniques, parameters, etc., may be conjointly employed in this invention. Accordingly, the term "comprising" encompasses the more restrictive terms "consisting essentially of" and "consisting of."

An embodiment of this invention broadly comprises a method for creating a tool specification by submitting a request which includes basic tool parameters to a tool data library, generating tool specification parameters based on the basic tool parameters submitted, importing the generated tool specification parameters into a parametric tool template, and processing the imported tool specification parameters and parametric tool template using a CAD software program to create the tool specification, wherein the tool specification comprises a representation of a three-dimensional model of the tool and associated drawing specifications for the tool. An embodiment of this invention also broadly comprises a requestor workstation for at least entering search requests and tool parameters and for at least reviewing created tool specifications, a tool data library accessible by the requestor workstation and comprising pre-existing tool specification data and pre-existing tool parameter data, a source of parametric tool templates modifiable with imported tool parameters, and a source of a CAD software program for processing the imported tool parameters and parametric tool templates to create the tool specifications.

One of the benefits which may be provided by these embodiments of the method and system of this invention is the ability to generate these tool specification parameters by searching the tool data library for pre-existing tool parameter data, and applying knowledge-based rules from the pre-existing tool parameter data ("best practices") to these basic parameters to provide the remaining tool parameters which, collectively, comprise the complete set of tool specification parameters. Another benefit which may be provided by these embodiments of the method and system of this invention is to enable the requestor to obtain a standard, fully defined tool specification relatively quickly upon submitting the basic tool parameters, e.g., potentially within minutes instead of weeks. Embodiments of the method and system of this invention may also provide the requester with, for example, computer screens (including, for example, dialog boxes) which may guide and aid the requestor in creating the tool specification, including, for example, providing guidance in entering the basic tool parameters needed to initiate a request for a tool specification, generating the tool parameter specifications needed to create the tool specification, providing the ability to modify the tool specification upon review by the requestor, etc. The tool specification which is created may also be saved, stored, etc., in the tool data library to augment the pre-existing tool specification data and pre-existing tool parameter data, to provide for further modification of the tool specification, to provide for retrieval of the tool specification as needed, etc.

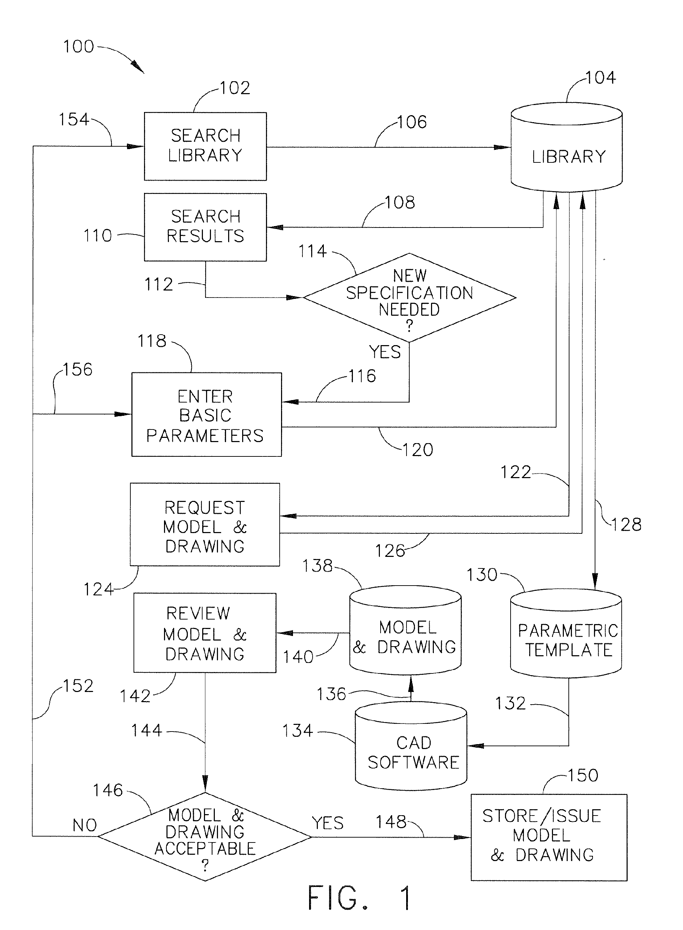

An illustrative method and system for creating a tool specification comprising a representation of a three-dimensional model and associated drawing specifications for a cutting tool such as, for example, a ball nose end mill, is illustrated by the flowchart shown in FIG. 1. The method/system of FIG. 1 which is indicated generally as 100, may be in the form of a stand-alone computer, computerized network, etc., or any combination of local and/or remote systems. As shown in FIG. 1, the initial step in method/system 100, indicated generally as rectangle 102, is for the requestor of the tool specification to search a tool data library (which may reside on one or more computers, and which may be accessed remotely or locally), indicated generally by cylinder 104, for pre-existing tool specifications. The search request, as indicated by arrow 106, is transmitted by the requestor from the requestor workstation (e.g., portable computer, desktop computer, other computer terminal, etc.) to library 104 and includes any criteria provided by the requestor about the tool specification sought or desired, including non-geometric tool parameters (e.g., tool materials, where used, etc.), and geometric tool parameters (e.g., cutting and shank diameter, flute length, overall length, corner radius, holding style, etc.). In response to the criteria provided in request 106, library 104 provides or retrieves, as indicated by arrow 108, search results 110 which contain whatever pre-existing tool specifications are contained within library 104 which meet, or appear to meet, the criteria provided in request 106.

As indicated by arrow 112, the requestor may review search results 110 to decide, as indicated by diamond 114, whether the pre-exiting tool specification provided from library 104 meets or appears to meet the criteria specified in request 106, or whether a new tool specification is needed. If a new tool specification is needed (a "YES" indicated by arrow 116), the requestor may then provide and enter basic tool parameters for creating a new tool specification, as indicated by rectangle 118. These entered basic tool parameters 118 are then submitted (e.g., transmitted), as indicated by arrow 120, to library 104 for the purpose of searching for "best practices" tool parameter data (using knowledge-based rules applied to the submitted basic tool parameters 118) which may be available in library 104 and which might be relevant in generating the remaining tool parameters required to complete the set of tool specification parameters needed to create the new tool specification. The relevant "best practices" tool parameter data which is available in library 104 based on the submitted basic tool parameters 118 is then retrieved, as indicated by arrow 122. This retrieved "best practices" tool parameter data 122, along with the submitted basic tool parameters 118, which may be saved in library 104, are used to generate the remaining tool parameters needed to complete the set of tool specification parameters for creating the new tool specification. After the complete set of tool specification parameters is generated, a request, as indicated by rectangle 124, to create a representation of a three-dimensional model of the tool and associated drawing specifications of the tool which comprise the new tool specification is then transmitted to library 104, as indicated by arrow 126. The transmission 126 of request 124 to library 104 causes the generated set of tool specification parameters to be retrieved and imported, as indicated by arrow 128, into a relevant, pre-existing parametric tool template (which may be in library 104 or which may be in another library accessible by method/system 100), as indicated by cylinder 130. The imported tool specification parameters 128 and parametric tool template 130 are then processed, as indicated by arrow 132, using CAD software program(s) (which may reside on the same computer which library 104 resides or which may reside on another computer accessible by method/system 100), as indicated by cylinder 134. CAD software program(s) 134 then transforms the imported tool specification parameters 128 and parametric tool template 130, as indicated by arrow 136" and thus creates a new tool specification comprising a three-dimensional tool model and the associated drawing specifications for the tool, as indicated by cylinder 138.

The new tool specification 138 comprising the model and associated drawing specifications are then transmitted, as indicated by the arrow 140, to the requestor workstation for review by the requestor, as indicated by rectangle 142. From the review in step 142, the requestor is then asked, as indicated by arrow 144, to make a decision, as indicated by diamond 146, as to whether the model and associated drawing specifications for the new tool specification 138 are acceptable ("YES") or are not acceptable ("NO"). If the requestor feels the model and associated drawing specifications for the new tool specification 138 are acceptable, as indicated by the "YES" arrow 148, the new tool specification 138 comprising the model and associated drawing specifications may be stored, issued, etc., as indicated by rectangle 150. If, instead, the requestor feels the model and associated drawing specifications for the new tool specification 138 are not acceptable (for example, require further modification), as indicated by the "NO" line 152, the requestor may initiate from the requestor workstation a further search of library 104 for additional pre-existing tool parameter data which might be relevant for modifying the model and/or associated drawing specifications, as indicated by arrow 154, or may directly provide the additional tool parameter data for modifying the model and/or associated drawing specifications, as indicated by arrow 156, without additionally searching library 104. The request to further modify the model and/or associated drawing specifications for the new tool specification may then be processed as before (i.e., by following steps 102 through 146 if the path indicated by arrow 154 is chosen, or by following steps 118 through 146 if the path indicated by arrow 156 is chosen). This modification cycle may be repeated one or more times (i.e., by repeating the step represented by arrow 146), until the requestor decides the modified model and/or associated drawing specifications are acceptable at step 146 and then stores, issues, etc., the accepted modified model and/or associated drawing specifications for the new tool specification in step 150.

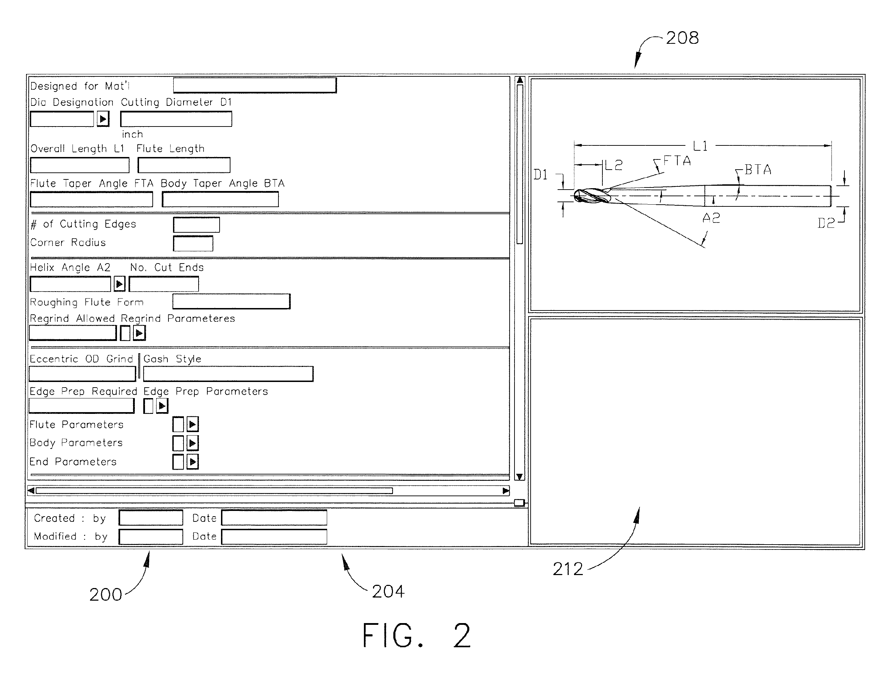

FIGS. 2 through 7 represent a sequential series of several computer screen captures from a computer display (e.g., computer monitor) which illustrate at least some of the steps carried out by method/system 100 for creating a new tool specification 138 for, for example, a ball nose end mill. FIG. 2 illustrates a blank starting screen, indicated as 200, which may be presented to the requestor for searching library 104, for entering basic tool parameters 118, for displaying the results of a search request 106, for displaying results 122 retrieved from library 104 from the basic tool parameters 118 submitted in step 120, etc. As shown in FIG. 2, screen 200 may be divided into, for example, three panels indicated as 204, 208 and 212. Panel 204 provides for entry and display of numerical information or data relating to the tool, including basic tool parameters 118, etc. Panel 208 provides a schematic display of the tool which may include a display of various labeled or identified tool parameters such as tool lengths (e.g., L1, L2), diameters (e.g., D1, D2), angles (e.g., FTA, BTA, A2), etc., and which may also be used to directly enter information or data relating to one or more of the displayed tool parameters, which may then be displayed in numerical fashion in panel 204. As shown in FIG. 2, panel 208 provides a display of a ball nose end mill from a pre-existing tool specification in library 104. Panel 212 may provide a display of a three-dimensional model of the pre-existing tool, or may be blank, as shown in FIG. 2.

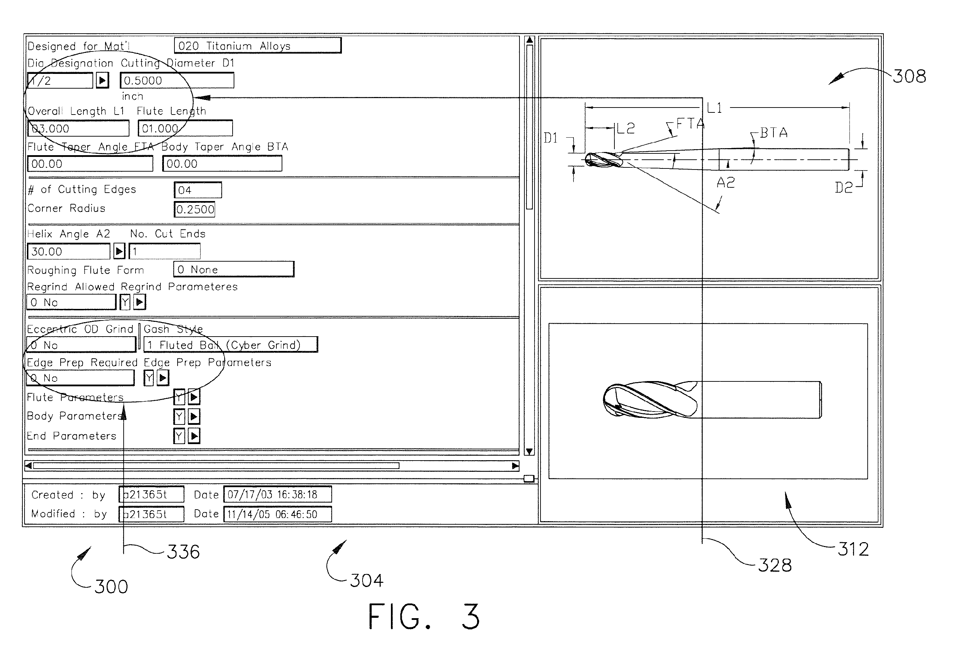

Using screen 200, the requestor may initiate a search (step 106) in library 104 for pre-existing tool specifications by entering the appropriate data into panels 204 and/or 208. FIG. 3 illustrates the search results 110 obtained after a search request 106 is transmitted to library 104 for the ball nose end mill. What is illustrated in FIG. 3 is a computer screen 300 having panels 304, 308 and 312, which correspond to, respectively, panels 204, 208 and 212 from screen 200. Panel 304 now contains entered and/or displayed tool parameter information and data, including geometric tool parameter data, indicated as 328, as well as non- geometric tool parameter data, indicated as 336, for the ball nose end mill requested in search request 106. Panel 312 also provides a three-dimensional display of a pre-existing ball nose end mill from library 104 based on the criteria provided in search request 106.

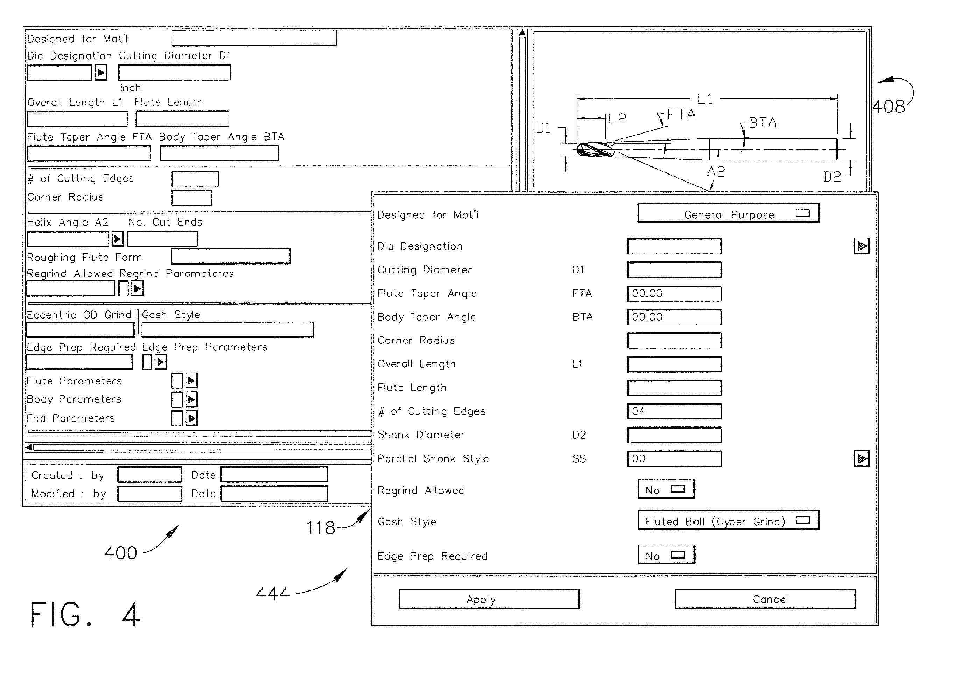

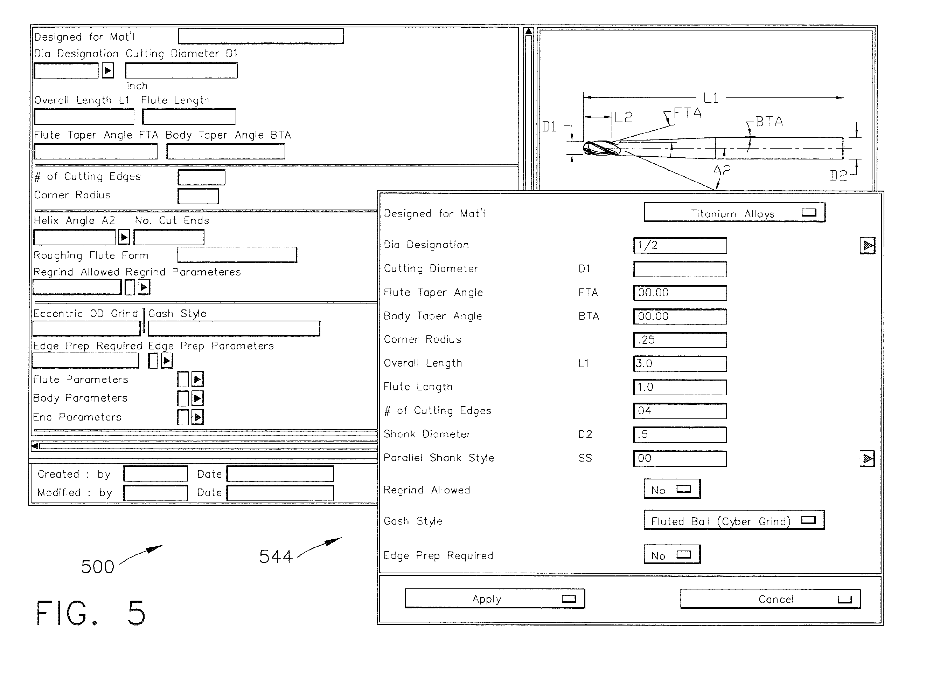

Assuming that the results 110 shown in screen 300 indicate to the requestor that a suitable pre-existing tool specification for the requested ball nose end mill does not exist in library 104, the requestor may then be presented with computer screen 400 shown in FIG. 4, which may include a dialog box 444 for entering basic tool parameters 118. As shown in FIG. 4, some of the tool parameters shown in dialog box 444 also include the designated labels or indicia for various tool parameters identified in panel 408 showing the schematic of the pre-existing ball nose end mill. FIG. 5 illustrates the completed entry of the basic tool parameters 118 in the dialog box, as shown in 544 of computer screen 500. The completed set of basic tool parameters 118 in dialog box 544 may then be submitted or transmitted (step 120) to library 104.

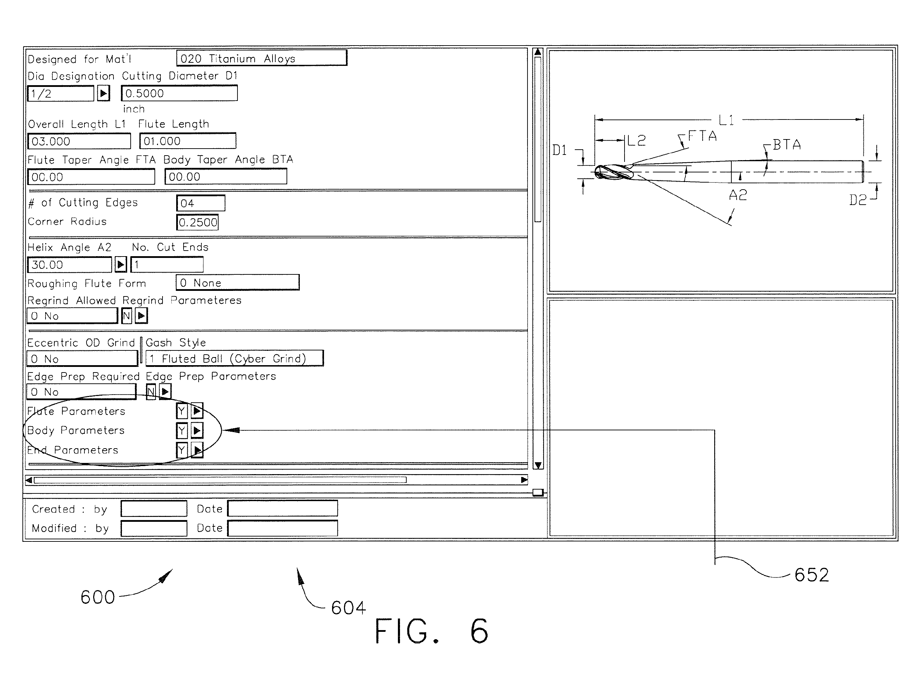

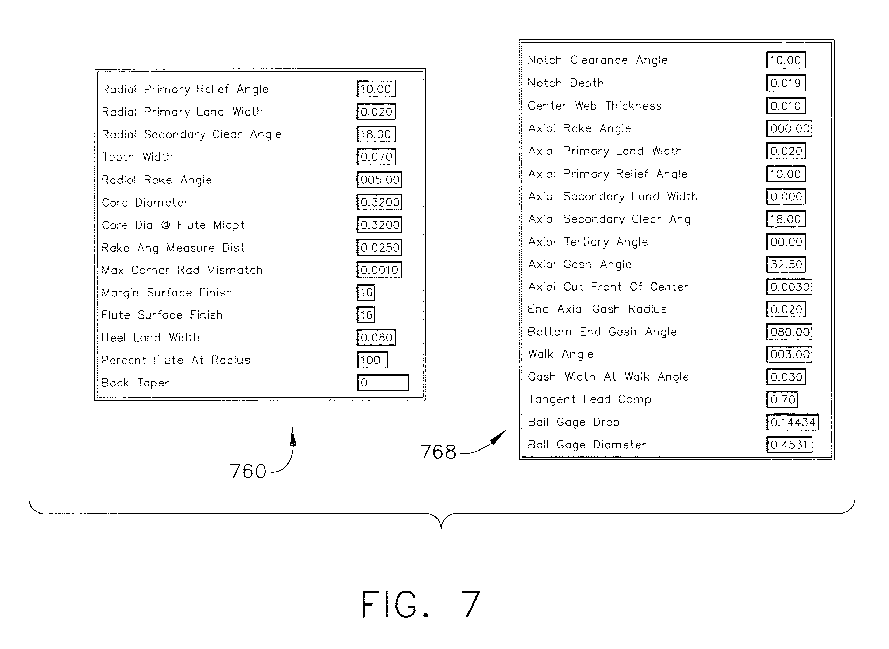

FIGS. 6 and 7 illustrate the results (step 122) which may be obtained from the submission of the completed set of basic tool parameters in dialog box 544. FIG. 6 shows computer screen 600 which includes panel 604 with the tool parameter data and information. The "best practice" tool parameters to be obtained by the submission of the complete basic tool parameters 118 in dialog box 544, are indicated in FIG. 6 as panel 652. In FIG. 7, computer screens 760 and 768 show a complete set of tool specification parameters (step 122) which are derived by applying knowledge-based rules from the "best practice" tool parameters in library 104 to the submitted complete set of basic tool parameters 118 entered in dialog box 544.

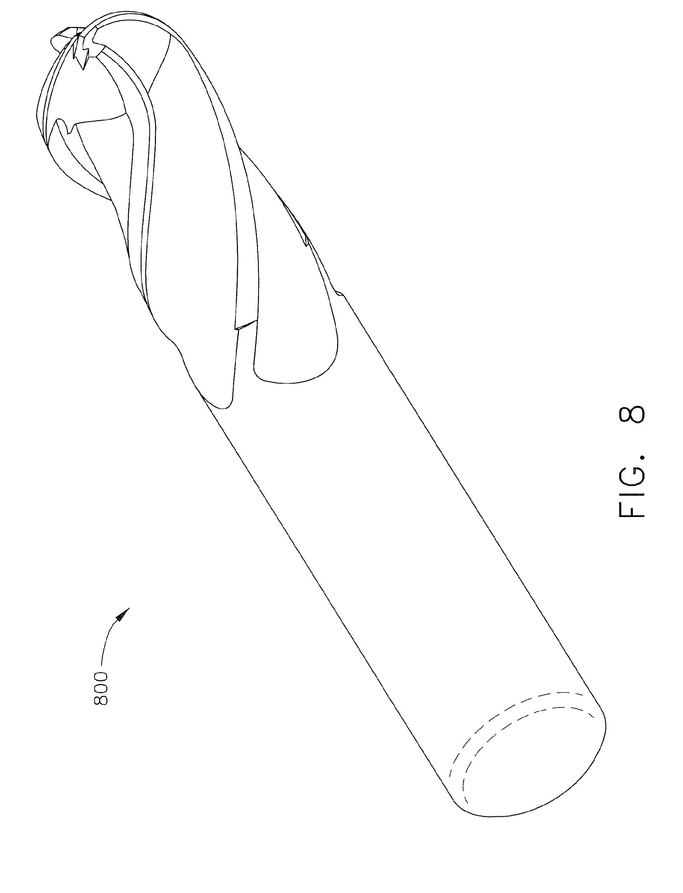

FIG. 8 illustrates the three-dimensional model 800 (step 138) of the ball nose end mill which may be created by transmitting the new tool specification request 124 (step 126), retrieving the complete set of tool specification parameters shown in screens 760 and 768 from library 104, importing these tool specification parameters into the parametric tool template 130 (step 128) and then processing these imported tool specification parameters and template 130 using CAD software program 134 .

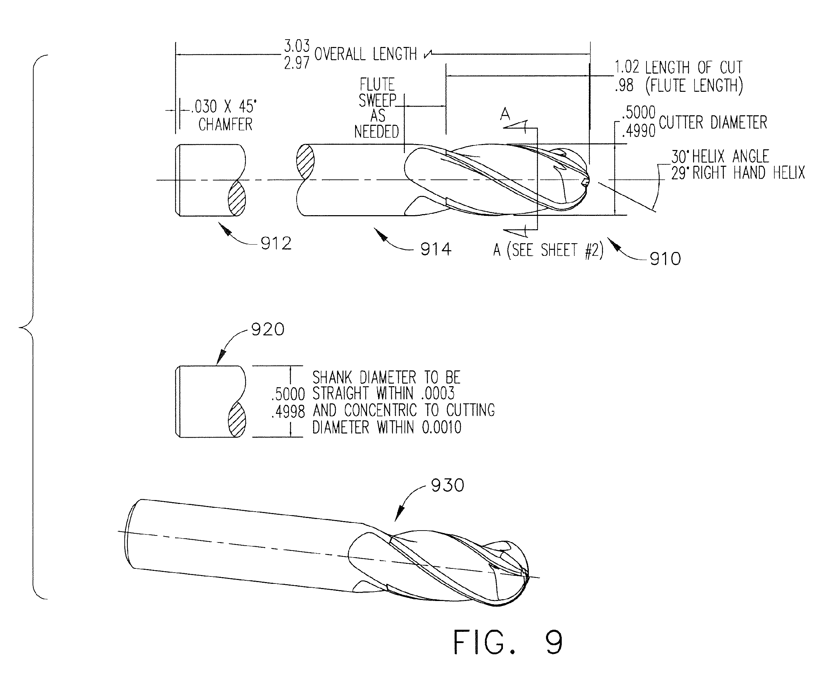

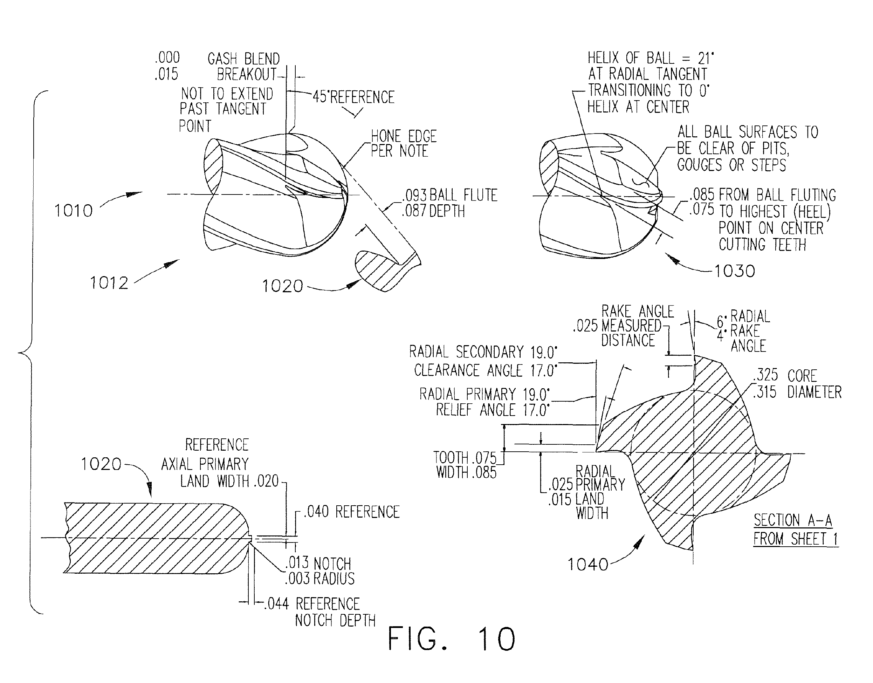

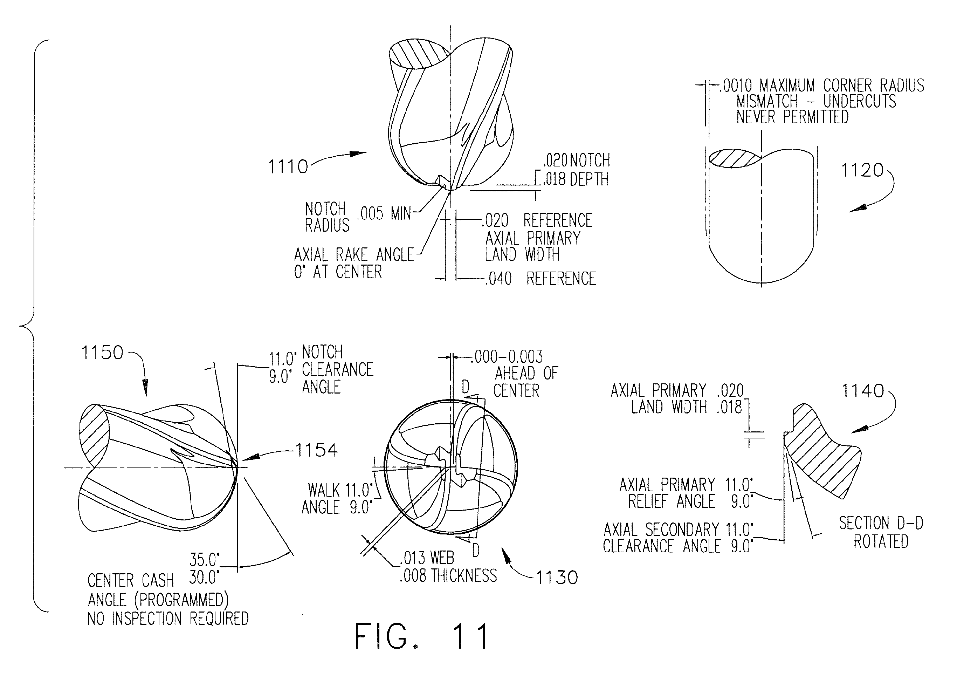

FIGS. 9 through 11 illustrate various enlarged portions of the associated drawing specifications for the ball nose end mill provided in tool specification 138. (These associated drawing specifications often appear in one panel of the computer screen, but are shown as various enlarged portions thereof in FIGS. 9 through 11 so that the details the drawing specifications may be more easily seen.) For example, FIG. 9 provides a side view 910 of the ball nose end mill which includes the cutting end 912 and a portion 914 of the shank end of the mill, a side view 920 showing only the portion 912 of the shank end, and a perspective view 930 of the cutting end 912. Views 910, 920 and 930 collectively provide an overall perspective of the ball nose end mill which may then be appropriately scaled when making, quoting, etc., the tool. FIG. 10 provides a side view 1010 of the cutting head 1012 of the ball nose end mill, a sectional view 1020 of one of the flutes 1022 from cutting head 1012 of view 1010, a different side view of cutting head 1012, a sectional view 1040 through the shaft of the ball nose end mill showing the flute configuration, and a side view 1050 showing a notch feature of the ball nose end mill. Views 1010 through 1050 are enlarged and collectively show the details of the ball nose end mill. FIG. 11 provides a vertical view 1110 of the cutting head 1012, , a side view 1120 showing the cutting head 1012 being revolved or rotated, an end on view 1130 of the cutting head 1012, sectional view 1140 of one of the flutes shown in view 1140, and a side view 1150 of the cutting head 1012 illustrating what happens at the tip 1154 of cutting head 1012. Like views 1010 through 1050, views 1110 through 1150 are enlarged and collectively show additional details of the ball nose end mill.

While specific embodiments of the method and system of this invention have been described, it will be apparent to those skilled in the art that various modifications thereto can be made without departing from the spirit and scope of this invention as defined in the appended claims.

## Claims

1. A method (100) comprising the following steps:
(a) submitting (106) to a tool data library (104) a request (102) to create a tool specification, wherein the request (102) includes basic tool parameters (118) for creating the tool specification;
(b) generating (122) tool specification parameters from the tool data library (104) based on the submitted basic tool parameters (118);
(c) importing (128) the generated tool specification parameters into a parametric tool template (130); and
(d) processing (132) the imported tool specification parameters (128) and parametric tool template (132) using a CAD software program (134) to create (136) the tool specification (138), wherein the tool specification (138) comprises a representation of a three-dimensional model (800) of the tool and associated drawing specifications (910 through 1150) for the tool.

2. The method (100) of claim 1 wherein the tool parameter specifications (122) of step (b) comprise the submitted basic tool parameters (118) and remaining tool parameters generated by applying knowledge-based rules from pre-existing tool parameter data in the tool data library (104) to the submitted basic tool parameters (118).

3. The method (100) of any claims 1 to 2 which comprises the additional step (e) of reviewing (142) the tool specification (138) after step (d) to determine whether or not the tool specification (138) is acceptable (144).

4. The method (100) of any claims 1 to 3 which comprises the additional step (f) of storing the tool specification (150) in the tool data library (104) if the tool specification is determined to be acceptable (144) in step (e).

5. The method (100) of any claims 1 to 4 which comprises the additional step (g) of modifying (152, 154, 156) the tool specification if the tool specification (138) is determined to be not acceptable (144) in step (e).

6. The method (100) of claim 5 wherein step (g) (152, 154, 156) is carried out by repeating steps (a) through (d) (106 through 142) one or more times.

7. A system (100) comprising:
a requestor workstation for at least entering search requests (106) and tool parameters and for at least reviewing created tool specifications;
a tool data library (104) accessible by the requestor workstation and comprising pre-existing tool specifications and pre-existing tool parameters;
a source of parametric tool templates (130) modifiable with imported tool parameters (128); and
a source of a CAD software program (134) for processing (132) the parametric tool templates (130) and imported tool parameters (128) to create (136) tool specifications (138), wherein each tool specification (138) comprises a representation of a three-dimensional model of a tool (800) and associated drawing specifications for the tool (910 through 1150).

8. The system (100) of claim 7 wherein one or more computer screens (200 through 600) are provided to the requestor workstation to guide in the use of the system (100).

9. The system (100) of any of claims 7 to 8 wherein one or more of the provided computer screens 200 through 600) are divided into at least three panels (204/304, 208/308/408, and 212/312), wherein the first panel (204/304) provides for entry and display of numerical information or data relating to the tool, wherein the second panel (208/308/408) provides a schematic display of the tool with one or more identified tool parameters, and wherein the third panel (212/312) provides the three-dimensional model (800) of the tool.

10. The system (100) of any of claims 7 to 9 wherein after the set of tool specification parameters is imported (128) into a parametric tool template (13o) and processed (132) by the CAD software program (134) to create (136) the tool specification (138), a computer screen is provided to the requestor workstation which displays a representation of the three-dimensional model (800) of the tool and the associated drawing specifications for the tool (910 through 1150).
